# EUROPEAN PATENT APPLICATION

(11) **EP 2 071 347 A2**
(43) Date of publication of application: **17.06.2009**
(21) Application number: 08021531.2
(22) Date of filing: 11.12.2008
(51) Int. Cl.: G01R 33/06

(54) **Twin vertical Hall sensor**

(30) Priority: 12.12.2007 GB 0724240
(71) Applicant: Melexis NV, 8900 Leper (BE)
(72) Inventor: Schott, Christian, 1167 Lussy-sur-Morges (CH)
(74) Representative: Wilson Gunn

(57) **Abstract**

A Hall sensor 300 comprises two separate wells 311 and 312 each having respective contacts 301, 302, 303 or 307, 308, 309 provided thereover. An oppositely directed bias current is supplied via contacts 301, 303 and 307, 309. Accordingly, a differential signal can be obtained from the two output contacts 302, 308. As in each well 311. 312 the middle contact 302, 308 can be precisely centred between the two outer contacts 301, 303 and 307, 309, the intrinsic offset is small. The sensor 300 can be subjected to reversed operation by reversing the bias current direction. This provides a sensor 300 with a low and temperature-stable offset.

## Description

The present invention relates to a vertical Hall sensor and in particular to a vertical Hall sensor having low offset and being adapted to spinning current operation and to such a Hall sensor suitable for CMOS implementation.

A vertical Hall sensor implemented on an integrated circuit die is operable to measure a magnetic field component parallel with the die surface. At its most basic the sensor comprises means for applying a bias current through a well and an output contact provided over the well such that the output contact experiences a Hall potential in response to the component of magnetic field in the plane of the well aligned perpendicular to bias current. Typically, two or more output contacts are provided and the bias current is applied in such a manner that each output contact experiences an opposite Hall potential, enabling a differential Hall voltage to be readout. The bias current may be applied by use of contacts of the same form as the output contacts.

Vertical Hall sensors are commonly implemented as a four-contact structure or as a five contact structure. These structures comprise the four or five contacts spaced along a linear well, the contacts being identified by numbering them consecutively from one end.

A high quality Hall sensor should fulfil two conditions: a) it has a small offset voltage between the output contacts which drifts little with temperature; and b) it is electrically equivalent (same input and output resistance) in at least two operation modes (spinning phases) between which biasing contacts and output contacts are interchanged.

This electrical equivalence enables spinning operation, that is the commutation of the pairs of biasing contacts and output contacts such that the intrinsic offset between the output contacts changes its sign, but not its magnitude between phases whilst the measured Hall voltage keeps the same sign and magnitude between phases. In this manner, the sum of the output voltages of both phases can be used to cancel the intrinsic offset very efficiently.

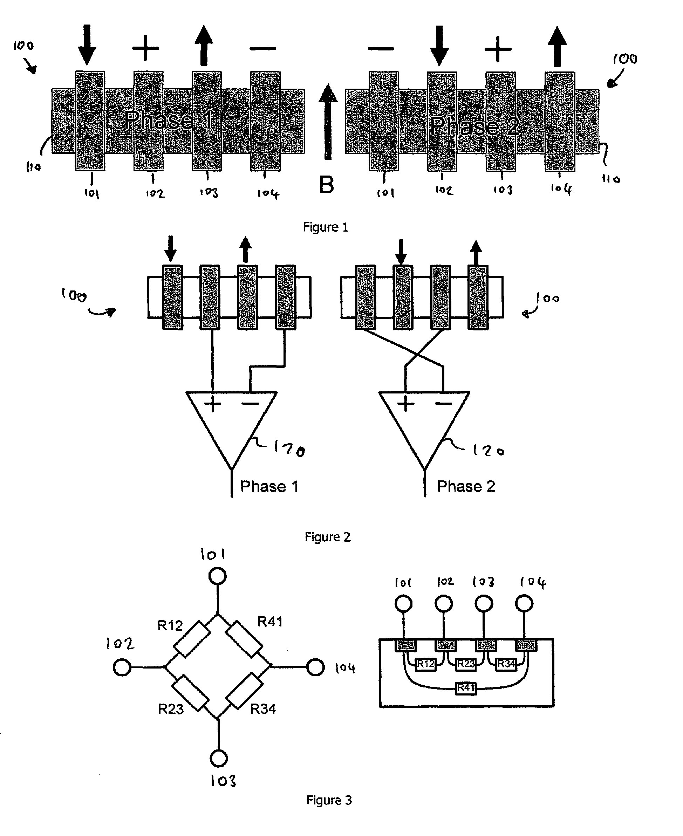

A four contact structure (see figs 1-3) has a first phase in which contacts 1 and 3 (101, 103 in figs 1-3) are used as biasing electrodes and contacts 2 and 4 (102, 104 in figs 1-3) are used as output contacts. In the second phase contacts 2 and 4 (102, 104) are used as biasing electrodes and contacts and 3 (101, 103) are used as output contacts. Electrically, this structure can be modelled as a four resistor bridge, however, whilst it is possible to arrange the structure such that the equivalent resistances R₁₂, R₂₃ and R₃₄ are equal, R₄₁ will differ. This leads to a field-equivalent offset of several Tesla. As a result, even with spinning current operation the residual offset is high.

Theoretically all four resistors (R₁₂, R₂₃, R₃₄ and R₄₁) can be made equal if the material is uniformly doped and infinite in depth and width. In CMOS technology however the well of very limited depth (of the order of the contact distance) and the doping level has a maximum at a certain depth and decreases exponentially towards the surface and the bottom. Under these conditions R₄₁ can not be made equal to the other three resistances.

One possible solution to this problem is described in EP1540748 (Schott et al). In this solution an additional resistor is added between contacts 1 and 4 of the four-contact device to re-balance the equivalent four resistor bridge. Whilst this works quite well under constant operating conditions (constant biasing, temperature, stress), if those conditions vary, the offset drifts due to secondary effects.

As an example, one such secondary effect is backbiasing from the substrate, that is the modulation of the thickness of the depletion layer between the p-substrate and the n-well depending on the local potential difference. Since the provision of an additional resistor varies the geometry of the well it also varies the backbiasing effect. Accordingly, the representative bridge becomes unbalanced if the local potentials change. Such a change may typically occur as a result of resistivity variation with temperature. Accordingly, the four contact device fulfils condition b), but not condition a).

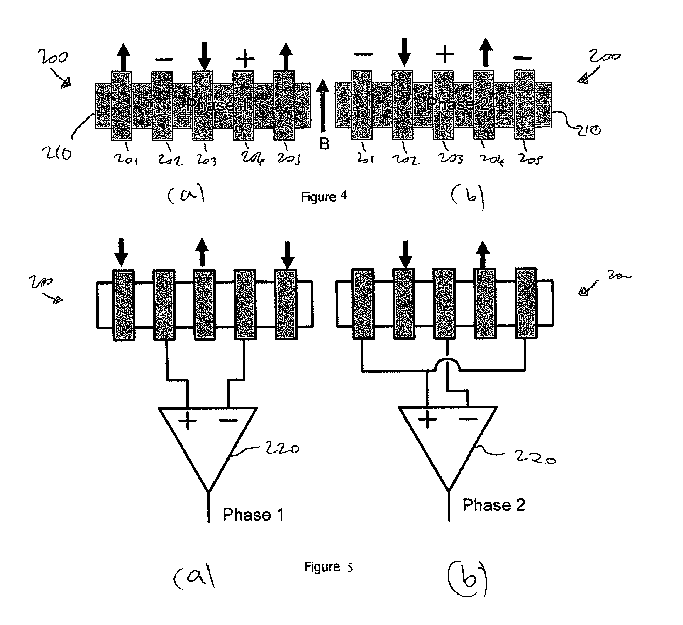

Turning now to the five contact device (see figs 4-5), it has two potential phases: a first phase (bias supply on 1, 3, 5 (201, 203, 205 in figs 4-5) and output on 2, 4 (202. 204 in figs 4-5)); and a second phase (bias supply on 2, 4 (202, 204) and output on 1, 3, 5 (201, 203, 205)). The five-contact device exhibits very low offset in both potential phases, when taken separately if it is adapted such that the equivalent resistor bridge is always balanced with respect to the output contacts. Here again, when implemented in CMOS, the drawback is that the first phase and the second phase are not electrically equivalent, as there are three biasing contacts in the first phase and only two biasing contacts in the second phase. As such the equivalent resistor bridge with respect to the biasing contacts is not balanced from phase to phase and therefore spinning operation is not possible. Accordingly, the five contact device fulfils condition a), but not condition b).

In summary, whilst both implementations work well under idealistic conditions, they both have drawbacks when implemented in CMOS. The reason for this is the limited well depth in CMOS and the non-uniform doping of the well from the surface into the substrate.

It is therefore an object of the present invention to provide a Hall sensor that at least partially overcomes or alleviates the above problems.

According to a first aspect of the present invention there is provided a Hall sensor comprising: a pair of substantially mutually isolated portions, each portion comprising: a well; and a plurality of contacts provided over the well and wherein the contacts are arranged such that a biasing current may be applied to each well by a pair of contacts of the respective portion so as to generate a Hall potential on another contact of the portion.

A Hall sensor according to the above may be adapted to feature a very low intrinsic offset and may be adapted to spinning current operation. By dividing a sensor into two substantially mutually isolated portions, the resistor bridge making up the sensor can be in equilibrium under all conditions as the substantially mutually isolated portions are substantially identical, only with an opposite current direction. If there is an offset in the Hall potential due to temperature effects, stress effects or backbiasing effects, this potential offset should be substantially equal on both substantially mutually isolated portions. It is therefore common to both substantially mutually isolated portions and does not add to the differential voltage between the two sense contacts. It thus overcomes the drawbacks of the prior art implementations and thus enables both condition a) and condition b) to be fulfilled.

Preferably the contacts are arranged in a linear manner along the well. The contacts may be substantially equally spaced along the well.

Preferably the portions are aligned such that they are operable to measure a common component of magnetic field. The portions are preferably operated in a phased spinning cycle such that in each phase the portions are oppositely biased such that each will experience an opposite Hall potential. Preferably, the common resistor in the spinning operation has always the same potential on one side.

In one implementation, each portion has three contacts. In such an implementation the end contacts may be used for applying a bias current and the middle contact may experience a Hall potential. Whilst such an implementation has a small offset voltage between the output contacts which drifts little with temperature, it is not strictly adapted for spinning operation, since for spinning operation bias and output contacts need to be interchanged and there are only three contacts in the structure.

In an alternative implementation, adapted for spinning operation, each portion has four contacts, three of which are used in any one phase. Preferably in each phase in each portion one of the end contacts and the middle contact not adjacent to the said end contact are used for applying a bias current and the middle contact adjacent to the said end contact experiences a Hall potential. Preferably in the successive phase, the opposite end contact and non-adjacent middle contact are used for biasing and the other middle contact experiences the Hall potential.

In some embodiments, additional dummy contacts may be provided outside the contacts used in biasing and hall potential detection. The dummy contacts may facilitate further symmetrization of the portions during a spinning cycle.

The wells are preferably n-wells. In alternative embodiments, p-wells may be used how ever this may result in reduced sensitivity as the mobility of electrons is greater than that of holes. Each portion may be provided with electrically separate wells. Alternatively the portions may share a well but be positioned sufficiently far apart within the well to be substantially isolated. For example, cross currents between the portions of the order of 1% or less could be considered to be electrically isolated.

Preferably, the Hall potentials generated in each portion are input to a differential amplifier. The differential amplifier may generate an output for use by other circuitry.

In order that the invention is more clearly understood, one embodiment will be described further herein by way of example only and with reference to the accompanying drawings in which:
- Figure 1a: is a schematic illustration of a first operational phase of a four contact Hall sensor according to the prior art;
- Figure 1b: is a schematic illustration of a second operational phase of a four contact Hall sensor according to the prior art;
- Figure 2a: is a schematic illustration of the connection of the output contacts of the four contact Hall sensor of figure 1 to a differential amplifier in the first operational phase;
- Figure 2b: is a schematic illustration of the connection of the output contacts of the four contact Hall sensor of figure 1 to a differential amplifier in the second operational phase;
- Figure 3: is a schematic illustration of a four resistor bridge which can be used to model a sensor of the type shown in figures 1 and 2;
- Figure 4a: is a schematic illustration of a first operational phase of a five contact Hall sensor according to the prior art;
- Figure 4b: is a schematic illustration of a second operational phase of a five contact Hall sensor according to the prior art;

- Figure 5a: is a schematic illustration of the connection of the output contacts of the five contact Hall sensor of figure 4 to a differential amplifier in the first operational phase;
- Figure 5b: is a schematic illustration of the connection of the output contacts of the five contact Hall sensor of figure 4 to a differential amplifier in the second operational phase;
- Figure 6: is a schematic illustration of a twin Hall sensor according to the present invention;
- Figure 7a: is a schematic illustration of first operational phase of an alternative embodiment of a twin Hall sensor according to the present invention;
- Figure 7b: is a schematic illustration of a second operational phase of an alternative embodiment of a twin Hall sensor according to the present invention;
- Figure 8a: is a schematic illustration of the connection of the output contacts of the twin Hall sensor of figure 7 to a differential amplifier in the first operational phase; and
- Figure 8b: is a schematic illustration of the connection of the output contacts of the twin Hall sensor of figure 7 to a differential amplifier in the second operational phase.

Turing now to figures 1a and 1b, a four contact Hall sensor 100 according to the prior art comprises an n-well 110 provided on a p-substrate and four contacts 101-104 provided over the n-well 110. The Hall sensor 100 has a symmetrical structure and thus exhibits electrical equivalence (same input and output resistance) in at least two operation modes (spinning phases) between which biasing contacts and output contacts are interchanged. As such, the sensor is suited to spinning operation.

The two spinning phases are illustrated in figure 1a and figure 1b respectively. The arrows show the direction of the supply current flowing into and out of the contacts and the + and - signs denote the polarity of the resulting Hall potential on the output contacts from a magnetic field component B. As can be clearly seen, in the first phase (figure 1a) contacts 101 and 103 are used for the application of a biasing current through well 110 and contacts 102 and 104 are used as output contacts. In the second phase (figure 1b) contacts 102 and 104 are used for the application of a biasing current through well 110 and contacts 101 and 103 are used as output contacts.

Turning now to figure 2a and figure 2b, these illustrate how the output contacts In each phase are connected to the inverting and non-inverting inputs of a differential amplifier 120. This generates an output signal useable by external circuitry.

Electrically, this structure can be modelled as a four resistor bridge, as is illustrated in figure 3. Whilst it is possible to arrange the structure such that the equivalent resistances R₁₂, R₂₃ and R₃₄ are equal, R₄₁ will differ. This leads to a field-equivalent offset of several Tesla. As a result, even with spinning current operation the residual offset is high.

One possible solution, described in EP1540748, is to add an additional resistor between contacts 101 and 104 of the sensor 100 to re-balance the equivalent four resistor bridge. Whilst this works quite well under constant operating conditions (constant biasing, temperature, stress), if those conditions vary, the offset drifts due to secondary effects such as backbiasing from the substrate. Accordingly, the sensor 100 whilst demonstrating electrical equivalence does not have a stable small offset over variation in temperature.

Turing now to figures 4a and 4b, a five contact Hall sensor 200 according to the prior art comprises an n-well 210 provided on a p-substrate and five contacts 201-205 provided over the n-well 210. The sensor 200 is operable in two different phases illustrated in figures 5a and 5b respectively. In phase 1, biasing current is supplied to contacts 201, 203, 205 and contacts 202, 204 are used to detect an output. In phase 2, biasing current is supplied to contacts 202, 204 and contacts 201, 203, 205 are used to detect an output. Figures 5a and 5b respectively illustrate how the selected output contacts in the first phase and second phase are connected to the inverting and non-inverting inputs of a differential amplifier 220 to produce a useable output signal.

The sensor 200 has two potential phases: the first phase (bias supply on 201, 203, 205 and output on 202, 204); and the second phase (bias supply on 202, 204 and output on 201, 203, 205). As the sensor 200 can be adapted such that the equivalent resistor bridge is always balanced with respect to the selected output contacts, the sensor 200 exhibits very low offset in both potential phases, when taken separately.

Unfortunately, the first phase and the second phase are not electrically equivalent as the number of biasing contacts differs between phases. Therefore spinning operation is not possible even though each phase exhibits a low inherent offset.

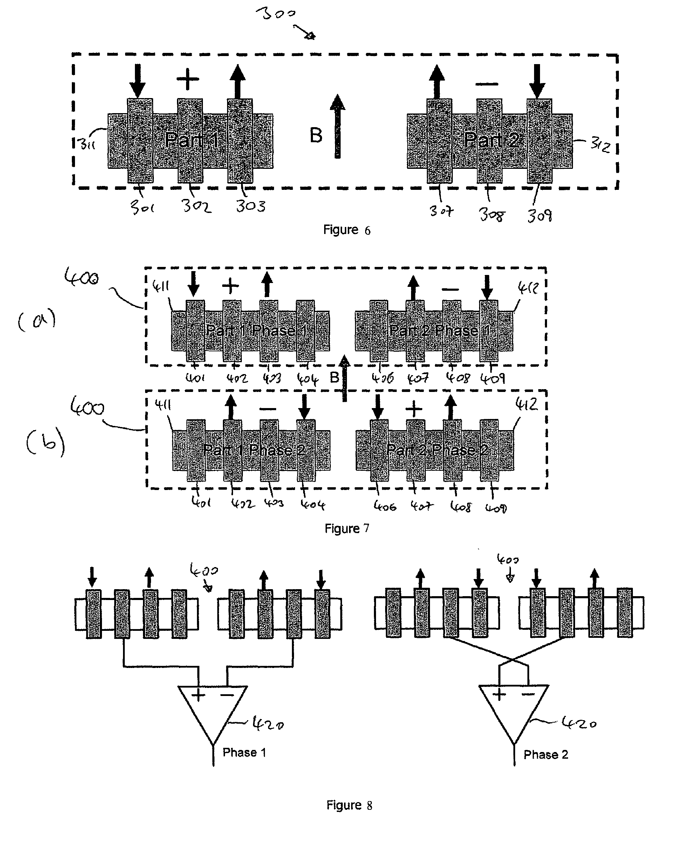

Turning now to figure 6, a simplified illustration of a Hall sensor 300 according to the present invention is shown. The structure shown is basic structure showing the differential output character for measuring the Hall voltage according to the present invention. In the Hall sensor 300 two separate wells 311 and 312 are provided each having respective contacts 301, 302, 303 or 307, 308, 309 provided thereover The bias current is supplied via contacts 301, 303 and 307, 309 is oppositely directed Accordingly, a differential signal can be obtained from the two output contacts 302, 308. As in each well 311, 312 the middle contact 302, 308 can be precisely centred between the two outer contacts 301, 303 and 307, 309, the intrinsic offset is small. Whilst such a sensor 300 can be subjected to reversed operation by reversing the bias current direction, this is not strictly spinning operation, since for spinning operation bias and output contacts need to be interchanged. This provides a sensor 300 with a low and temperature-stable offset.

Turning now to figure 7, an improved embodiment of sensor 400 according to the present invention is shown, this embodiment being adapted for spinning operation. This sensor 400 comprises two separate n-wells 411 and 412 are provided each having respective contacts 401, 402, 403, 404 or 406, 407, 408, 409 provided thereover. The provision of an extra contact 404, 406 on each well 411, 412 enables spinning operation within each part of the sensor 400 as well as over the sensor 400 as a whole.

The spinning phases of sensor 400 are illustrated in figures 6a and 6b respectively, whilst the connections of each phase to the inverting and non-inverting inputs of a differential amplifier 420 are shown in figures 8a and 8b respectively.

In figure 8a, in the first phase of operation oppositely directed bias current is supplied via contacts 401, 403 and 407, 409. Accordingly, a differential signal can be obtained from the two output contacts 402, 408. In figure 8b, in the second phase of operation oppositely directed bias current is supplied via contacts 402, 404 and 406, 408. Accordingly, a differential signal can be obtained from the two output contacts 403, 407 as in a conventional Hall sensor 100, 200.

As long as the contacts 401-404 and 406-408 are equally spaced, the first phase and second phase of each part of sensor 400, taken individually, are electrically equivalent. Thus, when considered as a whole, both phases are also electrically equivalent. Additionally, the output contact of each part which is between the two biasing contacts in each phase will always be close to mid-potential of the biasing contacts plus the Hall potential. Accordingly, the intrinsic offset of the sensor 400 will be small. Furthermore, if the resistivity of the material changes with temperature, this will lead to a common mode shift of the contacts 401-404 and 406-409 and thus will, to a first approximation, have no effect on the voltage between them. This illustrates that the present invention provides a sensor 400 operable in spinning mode with a low and temperature-stable offset.

It is of course to be understood that the present invention is not to be limited to the details of the above embodiments which are described by way of example only.

## Claims

1. A Hall sensor comprising: a pair of substantially mutually isolated portions, each portion comprising: a well; and a plurality of contacts provided over the well and wherein the contacts are arranged such that a biasing current may be applied to each well by a pair of contacts of the respective portion so as to generate a Hall potential on another contact of the portion.

2. A Hall sensor as claimed in claim 1 wherein the contacts are arranged in a linear manner along the well.

3. A Hall sensor as claimed in claim 1 or claim 2 wherein the contacts are substantially equally spaced along the well.

4. A Hall sensor as claimed in any preceding claim wherein the portions are aligned such that they are operable to measure a common component of magnetic field.

5. A Hall sensor as claimed in any preceding claim wherein the portions are operated in a phased spinning cycle such that in each phase the portions are oppositely biased such that each will experience an opposite Hall potential.

6. A Hall sensor as claimed in any preceding claim wherein the common resistor in the spinning operation has always the same potential on one side.

7. A Hall sensor as claimed in any preceding claim wherein each portion has three contacts and wherein the end contacts are used for applying a bias current and the middle contact experiences a Hall potential.

8. A Hall sensor as claimed in any one of claims 1 to 6 wherein each portion has four contacts, three of which are used in any one phase.

9. A Hall sensor as claimed in claim 7 wherein in each phase in each portion one of the end contacts and the middle contact not adjacent to the said end contact are used for applying a bias current and the middle contact adjacent to the said end contact experiences a Hall potential and in the successive phase, the opposite end contact and non-adjacent middle contact are used for biasing and the other middle contact experiences the Hall potential.

10. A Hall sensor as claimed in any preceding claim wherein additional dummy contacts are provided outside the contacts used in biasing and hall potential detection.

11. A Hall sensor as claimed in any preceding claim wherein the wells are n-wells.

12. A Hall sensor as claimed in any preceding claim wherein each portion is provided with electrically separate wells or wherein the portions share a well but are positioned sufficiently far apart within the well to be substantially isolated.

13. A Hall sensor as claimed in any preceding claim wherein the Hall potentials generated in each portion are input to a differential amplifier.

14. A Hall sensor as claimed in claim 13 wherein the differential amplifier generates an output for use by other circuitry.
